(19) Europäisches Patentamt
European Patent Office
Office européen des brevets

(11) Publication number: **0 433 696 B1**

# (12) EUROPEAN PATENT SPECIFICATION

(45) Date of publication of patent specification: **04.10.95**  (51) Int. Cl.6: **G01R 19/165**, G11C 5/14

(21) Application number: **90122394.1**

(22) Date of filing: **23.11.90**

(54) **A circuit with hysteresis for power supply voltage detection.**

(30) Priority: **20.12.89 US 453550**

(43) Date of publication of application:
**26.06.91 Bulletin 91/26**

(45) Publication of the grant of the patent:
**04.10.95 Bulletin 95/40**

(84) Designated Contracting States:
**DE FR GB IT NL**

(56) References cited:
**EP-A- 0 093 606**
**EP-A- 0 218 451**
**DE-A- 2 507 780**
**FR-A- 2 613 491**
**US-A- 4 506 168**

(73) Proprietor: **TEXAS INSTRUMENTS INCORPO-
RATED
13500 North Central Expressway
Dallas
Texas 75265 (US)**

(72) Inventor: **Iyengar, Narashimhan
4425 Early Morn Drive
Plano,
Texas 75093 (US)**

(74) Representative: **Leiser, Gottfried, Dipl.-Ing. et
al
Prinz & Partner,
Manzingerweg 7
D-81241 München (DE)**

## Description

This invention is in the field of integrated circuits, and is more specifically directed to a circuit for detecting a power supply voltage.

### Background of the Invention

In integrated circuits, it may be useful to have a circuit incorporated therein to detect the level of a power supply voltage externally applied to the integrated circuits. One use of such a detection circuit is to detect an overvoltage condition at the power supply terminal. Such overvoltage detection is especially useful where certain portions of the integrated circuit can be damaged by an overvoltage condition. For example, in dynamic random access memories (dRAMs), the memory cells consist of metal-oxide-semiconductor (MOS) capacitors. In order to store a large amount of charge in a small surface area of the chip, the thickness of the capacitor dielectric is made as thin as possible, for example on the order of 10 nm for high density dRAMs such as 16 Mbit dRAMs. The potential across such thin capacitor dielectrics must, of course, be limited so that the capacitor dielectric integrity is not damaged by excessive voltage applied to the device. Accordingly, such power supply voltage detection circuits can be used to disable sensitive portions of the circuit responsive to the power supply voltage having a magnitude greater than a certain value. Alternatively, the integrated circuit may have a reduced voltage available on-chip, so that in the event of the overvoltage condition, the reduced voltage can instead be applied to the sensitive portions of the chip.

Such a detection circuit can also be used for detecting a power-up state, with the output of the detection circuit used to enable other circuitry on the integrated circuit chip only after the power supply voltage has reached a sufficient voltage. By not enabling such other circuitry until after a certain point in the power-up sequence, the integrated circuit can avoid metastable conditions which can arise during power-up.

Another use of such a circuit in detecting an overvoltage condition is to detect when a special mode or function is to be entered or performed. For example, as described by McAdams et al., in "A 1-Mbit CMOS Dynamic RAM With Design-for-Test Functions," J. Sol. State Circ., Vol. SC-21, No. 5 (IEEE, Oct. 1986), pp.635-42, an overvoltage condition on an input pin (such as a clock or address input pin) can be used for selecting a test mode for a dynamic RAM circuit. In such a case, the integrated circuit responds to the overvoltage condition on the input pin by entering a particular functional mode.

Simple comparator circuits may be used, of course, for comparing a power supply voltage to a reference value in order to determine a power-up or overvoltage condition. However, if a single trip point is used for both positive-going and negative-going transitions of the power supply voltage, small variations in the power supply value around the trip point voltage, caused by noise or power supply ripple, for example, would in turn cause the output of the detection circuit to oscillate. It is therefore preferable that the power supply voltage detection circuit have a transfer characteristic which includes hysteresis, so that small variations in the power supply voltage around a single trip point would not cause the detection circuit to oscillate.

Hysteresis may be provided into such circuits by way of conventional circuits such as Schmitt triggers. An example of a circuit for presenting a reset pulse responsive to a power supply voltage reaching a certain level, with the circuit including a Schmitt trigger, is described in U.S. Patent No. 4,716,322 issued December 29, 1987, and assigned to Texas Instruments Incorporated. However, the trip points for such circuits generally depend upon transistor sizes (e.g., width/length ratio for MOSFETs), and the size ratios of certain transistor pairs and groups in the detection circuit. Since the W/L ratios of modern MOS transistors heavily depend upon the patterned and etched size of the gate electrode, the hysteresis and operation of such circuits heavily depend upon the photolithographic manufacturing capability of the wafer fabrication factory. It should further be noted that since the gate electrode for an MOS transistor is generally one of the smallest feature sizes in the device, the patterning and etching of the gate electrode is often close to the limits of the manufacturing process. Accordingly, such circuits which depend upon relative W/L ratios of the transistors depend strongly upon that portion of the fabrication technology which is often the most difficult to control.

A voltage control circuit for an energy storing device is disclosed in DE-A-25 07 780. Hysteresis in this circuit is realized using a fixed number of diodes, so that no circuit characteristic variation may occur during operation. Compensation of supply voltage variation is partly achieved by an RC member and the circuit is primarily used to avoid the destruction of batteries.

U.S. Patent 4,506,168 shows a Schmitt trigger having a feedback mechanism between two inverter stages and U.S. Patent 4,709,165 shows a voltage detection circuit having a plurality of load devices arranged as part of an open loop circuit. However, the first document does not disclose a supply detection circuit and the thrust of the second invention is to minimize the number of elements used in the circuit, so that no variation of circuit characteristics is possible once the circuit is in operation.

It is an object of this invention to provide a power supply voltage detection circuit which has hysteresis in its transfer characteristic.

It is a further object of this invention to provide such a detection circuit which has trip points which do not strongly depend upon transistor sizes, and the relative sizes of transistors in the circuit.

Other objects and advantages of the invention will be apparent to those of ordinary skill in the art having reference to the following specification together with the reference.

Summary of the Invention

The invention may be incorporated into a power supply voltage detection circuit having a plurality of load devices, for example transistors configured as diodes, having their conductive paths connected in series between the power supply node and a drive transistor. The drive transistor has its gate connected to a reference voltage. The sum of the threshold voltages of the load transistors is used in setting the value above the reference voltage that the power supply node must reach in order for the drive transistor to drive its output node. A feedback transistor is connected across one or more of the load devices, and has its gate coupled to the output node of the drive transistor so that it is conductive responsive to the power supply node being above the desired trip point. With the feedback transistor in its conductive state, one or more of the load devices is shorted out, so that the series chain of load devices is effectively made shorter. The voltage of the power supply node must then drop below the original trip point in order to cause the drive transistor to turn off, creating the hysteresis in the transfer characteristic of the circuit.

Brief Description of the Drawings

Figure 1 is an electrical diagram, in schematic form, of a circuit according to the preferred embodiment of the invention.

Figure 2 is the transfer characteristic of the circuit of Figure 1 according to the preferred embodiment of the invention.

Detailed Description of the Preferred Embodiment

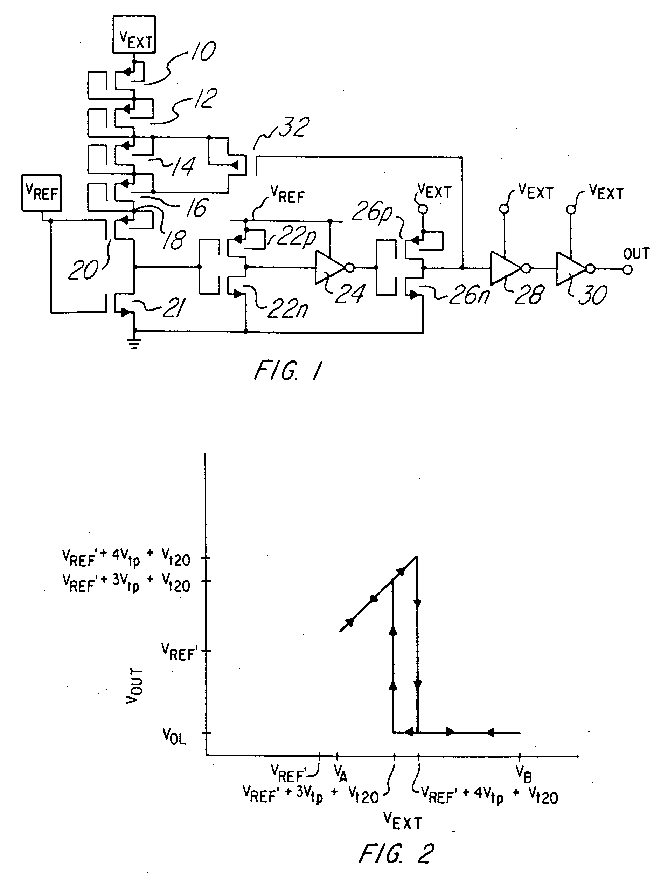

Referring now to Figure 1, the construction of a power supply voltage detection circuit according to the preferred embodiment of the invention will be described in detail. The circuit of Figure 1 has a terminal VEXT, at which the voltage to be detected is received. Terminal VREF receives a reference voltage against which the voltage at terminal VEXT will be measured. The reference voltage at terminal VREF is generated by a reference voltage generation circuit, such as a conventional bandgap voltage reference circuit.

Terminal VEXT corresponds to the terminal which receives the applied voltage that is to be compared by the circuit of Figure 1 in order to determine if it has exceeded a particular value. For the embodiment described hereinbelow, terminal VEXT corresponds to a power supply terminal for receiving an externally applied power supply voltage, and the description hereinbelow will, accordingly, refer to terminal VEXT as receiving a power supply voltage. It should be noted, however, that the circuit of Figure 1 may be used to determine an overvoltage condition on another terminal of the integrated circuit, for example a clock pin or an address pin. As noted hereinabove, an overvoltage condition on such an input pin can be used to enable a particular function or functional mode, such as a test mode. Such other uses of the circuit of Figure 1 will also benefit from the advantages of the invention as described hereinbelow.

For the case where terminal VEXT receives a power supply voltage, it should be noted that the reference voltage generation circuit will likely also be powered by the power supply voltage received at terminal VEXT, and accordingly the circuit of Figure 1 will likely be operable within a range of voltage VEXT above a certain value (as indicated in the transfer characteristic illustrated in Figure 2). Accordingly, the circuit of Figure 1 is especially applicable for detecting an overvoltage condition for the externally applied power supply voltage, since the reference voltage at terminal VREF (which the voltage at terminal VEXT must exceed in order to reach the overvoltage condition) can be sufficiently high so that the logic in the detection circuit is operable. However, conventional reference voltage generator circuits, such as bandgap reference circuits, can produce a stable reference voltage at reduced power supply bias voltages, as is well known in the art; accordingly, the circuit of Figure 1 can also be used for power-up detection, as well.

Terminal VEXT is connected to the source and substrate node of a p-channel transistor 10. P-channel transistor 10 has its gate tied to its drain. A series of p-channel transistors 12, 14, and 16 are connected in series with p-channel transistor 10, all similarly configured (i.e., each with its substrate node tied to its source, and its gate tied to its drain). The configuration shown in Figure 1, where the substrate nodes of transistors 10, 12, 14 and 16 are tied to their sources is preferred in this embodiment, as such a configuration will result in a constant threshold voltage for the transistors. It should be noted that the substrate nodes of transistors 10, 12, 14 and 16 can alternatively be biased by another voltage, for example the voltage at terminal VEXT. However, due to the body effect, such connection would result in the threshold voltage of transistors 10, 12, 14 and 16 varying with the voltage at terminal VEXT.

P-channel transistors 10, 12, 14, and 16 thus form a series of transistors operating in the triode region, and having current-voltage characteristics similar to that of a diode, with a voltage drop thereacross approximately at the threshold voltage of the transistor (hereinafter referred to as Vtp). Accordingly, the connection of transistors 10, 12, 14 and 16 in Figure 1 is commonly referred to as the diode configuration for MOS transistors. In the circuit of Figure 1, the source of the top transistor 10 is connected to terminal VEXT, and its drain is connected to the source of transistor 12. The other transistors 14 and 16 are similarly connected drain-to-source in series, with the drain and gate of transistor 16 at a node 18. The width-to-length (W/L) ratios of transistors 10, 12, 14 and 16 are preferably the same, and are preferably quite large, for example at a value on the order of 100, to provide a fast response time for the circuit of Figure 1. Of course, smaller sizes for transistors 10, 12, 14 and 16 could be used, depending upon the response time requirements for the voltage detection circuit in its particular application. Transistors 10, 12, 14 and 16 thus cause the voltage at node 18 to have a value which is approximately the voltage at terminal VEXT less, in this example, the sum of the threshold voltages transistors 10, 12, 14 and 16.

It will of course be apparent that more or fewer transistors than the four transistors 10, 12, 14 and 16 may be used to form the series of load devices, with the number of load devices depending upon the voltage values, relative to the voltage at terminal VREF, at which transitions of the output of the circuit are desired. In addition, it should be noted that other types of load devices, for example simple p-n junction diodes, may alternatively be used in place of transistors 10, 12, 14 and 16 configured as diodes. The choice of diode type will, of course, depend upon ease of fabrication and other factors.

Node 18 is connected to the source of a p-channel drive transistor 20. The gate of transistor 20 is connected to terminal VREF, and the drain of drive transistor 18 is connected to the gates of transistors 22p and 22n, which form a CMOS inverter. The source of p-channel transistor 22p is connected to the potential of terminal VREF, the source of n-channel transistor is connected to ground, and the drains of transistors 22n and 22p are connected together in the conventional manner for a CMOS inverter. The relative sizes of transistors 22n and 22p may be set to have the desired switching characteristic for the particular circuit application, for example with the width-to-length ratio of transistor 22p twice that of transistor 22n, due to the difference in mobility between p-channel and n-channel transistors. However, it should be noted that the relative sizes of transistors 22n and 22p is not of particular importance in practicing the instant invention.

The drains of transistors 22n and 22p are connected to the input of CMOS inverter 24. CMOS inverter 24 is similarly constructed as the inverter formed by transistors 22p and 22n, and is preferably biased by the voltage at terminal VREF. The output of inverter 24 is connected to the gates of transistors 26p and 26n, which form another CMOS inverter.

In the inverter formed by transistors 26p and 26n, the source of transistor 26p is biased by the voltage at terminal VEXT, the source of transistor 26n is connected to ground, and the drains of transistors 26p and 26 connected together. It is preferable, in this embodiment, that the width-to-length ratio of transistor 26n be much larger than the width-to-length ratio of transistor 26p. For example, transistor 26n may have a W/L of about 15, while the W/L ratio of transistor 26p may be on the order of 4. The relatively small size for transistor 26p is preferred in this example since inverter 24 is biased by the voltage at terminal VREF while the source of transistor 26p is biased by the voltate at terminal VEXT. Since the voltage at VEXT exceeds the voltage at VREF when the voltage at VEXT has passed the positive-going trip point, transistor 26p will have a higher voltage at its source than at its gate, and Will likely not turn off in this state. The small size of transistor 26p thus provides reduced DC power dissipation through the inverter formed by transistors 26n and 26p, when the voltage at terminal VEXT has exceeded the positive-going trip point.

The drains of transistors 26n and 26p are connected to the input of an inverter 28, which is biased by the voltage at terminal VEXT. The output of inverter 28 is connected, in turn, to the input of inverter 30, which is also biased by the voltage at terminal VEXT. The output of inverter 30 serves as the output of the circuit, driving terminal OUT. Inverters 28 and 30 serve as buffers for the output of the circuit, and to set the logical output of the circuit relative to whether or not the external voltage at terminal VEXT is over the desired threshold. In this embodiment, a low logic level signal is desired at terminal OUT responsive to the voltage at terminal VEXT exceeding a defined value greater than the voltage at terminal VREF, as will be described hereinbelow.

According to this embodiment of the invention, p-channel transistor 32 provides feedback to the series chain of transistors 10, 12, 14 and 16. The source and substrate node of transistor 32 is connected to the source of one of the transistors in the chain, in this case transistor 14. The drain of transistor 32 is connected to the source of another transistor in the chain, in this case the source of transistor 16. The gate of transistor 32 is connected to a point in the output buffer chain in such a manner that transistor 32 is conductive responsive to the voltage at terminal VEXT being above the desired threshold. In this example, the gate of transistor 32 is connected to the drains of transistors 26p and 26n.

The purpose of transistor 32 is to change the electrical length of the series chain of transistors 10, 12, 14 and 16, responsive to the voltage at terminal VEXT. In the example of Figure 1, when transistor 32 is conductive, transistor 14 is shorted out by transistor 32, so that only three transistors are electrically in series between terminal VEXT and node 18, instead of all four transistors 10, 12, 14 and 16 which are electrically in series when transistor 32 is off. Of course, the source-to-drain path of feedback transistor 32 can alternatively be connected across a different one of transistors 10, 12, 14 and 16 to achieve the same hysteresis effect as will be described hereinbelow. In addition, feedback transistor 32 may be connected across more than one transistor 10, 12, 14 and 16 in the chain, if the hysteresis loop in the transfer characteristic is desired to be wider.

The source/drain path of n-channel transistor 21 is connected between the drain of transistor 20 and ground. The gate of transistor 21 receives the reference voltage, shown by terminal VREF. The purpose of transistor 21 is to ensure that the node at the gates of transistors 22p and 22n is fully discharged when the voltage at terminal VEXT is below the detection value. In the case where the circuit of Figure 1 is intended to detect an overvoltage condition at terminal VEXT (i.e., a power supply voltage above the specified operating voltage), transistor 20 will remain in the off condition and transistor 21 will be conductive, so that the logic state at the gates of transistors 22n and 22p is at a defined low level. Since transistor 21 remains on even when transistor 20 is on (i.e., when an overvoltage condition is detected), due to its gate being at the reference voltage at VREF, the W/L ratio of transistor 21 is preferably much smaller than the W/L ratio of transistor 20. In the preferred embodiment, the W/L ratio of transistor 20 is on the order of 100, while the W/L ratio of transistor 21 is on the order of 0.05. This small W/L ratio for transistor 21 thus minimizes the DC current drawn from terminal VEXT through transistors 10, 12, 14, 16, 20 and 22 to ground.

The operation of the circuit of Figure 1 will now be described, with reference to the transfer characteristic of Figure 2. For purposes of this description, the transfer characteristic of Figure 2 begins with the voltage at terminal VEXT having a value VA which is sufficient to cause the reference voltage generator circuit (not shown in Figure 1) to place a reference voltage VREF' at terminal VREF which remains substantially at the value VREF' for power supply voltages above VA.

Transistor 20 will remain in the off state until the voltage at its drain, i.e., at node 18, exceeds the voltage VREF' at its gate by the value of the threshold voltage of transistor 20. Since p-channel transistor 20 is preferably enhancement mode, the absolute value of the threshold voltage of p-channel transistor 20 will be hereinafter referred to as Vt20; of course, a depletion mode device may alternatively be used for transistor 20, with the appropriate change in the behavior of the circuit. However, since there are four transistors 10, 12, 14 and 16 in series between terminal VEXT and node 18, the voltage at node 18 is at a value approximately the voltage at terminal VEXT less the threshold voltages of the transistors in the series chain, which in this case is 4Vtp. Therefore, transistor 20 does not turn on until the voltage at terminal VEXT reaches the value:

$$VREF' + 4Vtp + Vt20$$

With transistor 20 in the off-state, which is the case with the voltage at terminal VEXT at the value VA in Figure 2, transistor 21 pulls the voltage at the gates of transistors 22n and 22p to ground. This places the voltage VREF', biasing the source of transistor 22p, at the input to inverter 24. The output of inverter 24 is thus driven to ground, which turns on transistor 26p and turns off transistor 26n. The voltage at terminal VEXT is thus presented to the gate of transistor 32, keeping it in the off-state. Additionally, by the action of inverters 28 and 30 responsive to the voltage at the drains of transistors 26p and 26n being at VEXT, the voltage at terminal VEXT appears at the terminal OUT. According to this embodiment, this corresponds to a high logic level and indicates to the remainder of the integrated circuit within which the circuit of Figure 1 is incorporated that the power supply voltage applied to terminal VEXT is below the trip point. As shown in Figure 2, in this regime of the transfer characteristic, the voltage at terminal OUT follows the voltage at terminal VEXT, since the external power supply voltage is biasing inverter 30.

When the external power supply voltage at terminal VEXT reaches the value VREF' + 4Vtp +

Vt20, the voltage at node 18 (the source of transistor 20) is sufficiently high that transistor 20 turns on. This causes the voltage at the gates of transistors 22p and 22n to be at the value VREF' + 4Vtp + Vt20 which, in this preferred embodiment, is above the threshold voltage of transistor 22n so that the drains of transistors 22n and 22p are pulled to ground potential through transistor 22n. This causes the output of inverter 24 to go to the value VREF', which also is above the threshold voltage of transistor 26n, making transistor 26n conductive and transistor 26p substantially non-conductive.

Upon transistor 26n turning on, the input of inverter 28 is pulled low so that, via inverter 30, the output of the circuit at terminal OUT is pulled low (to VOL for the inverter) as shown in Figure 2. The low logic level at terminal OUT thus communicates that the external power supply voltage has reached the overvoltage trip point of VREF' + 4Vtp + Vt20, and the remainder of the integrated circuit which is responsive to terminal OUT can respond accordingly.

In addition, once transistor 26n has been turned on by the output of inverter 24, the gate of transistor 32 is pulled toward ground. This turns p-channel transistor 32 on, so that the source and drain of transistor 14 in the series diode chain are shorted together through transistor 32. This reduces the voltage which is required at terminal VEXT, in order for transistor 18 to remain on, by the threshold voltage of the transistors shorted out by transistor 32. In this case, since one transistor 14 is shorted out by transistor 32, the voltage at which terminal VEXT can remain to keep transistor 20 on, and in turn to keep the voltage at terminal OUT in the low logic level, is:

$$VREF' + 3Vtp + Vt20$$

Therefore, as the voltage at terminal VEXT drops from the value VB, which is above VREF' + 4Vtp + Vt20, the voltage at terminal OUT will remain low until the voltage at terminal VEXT drops to the value VREF' + 3Vtp + vt20. At this point, the voltage at terminal OUT will again substantially follow the value at terminal VEXT, as shown in Figure 2.

The circuit of Figure 1, according to the preferred embodiment of the invention, thus provides a power supply voltage detection circuit which has hysteresis in its transfer characteristic. This hysteresis reduces the possibility that small variations in the applied voltage around the trip point do not cause oscillations at the output of the circuit which, especially for the applications of this circuit to power-up and overvoltage detection, would render unstable the operation of the integrated circuit chip within which the circuit of Figure 1 is incorporated. For the circuit described relative to Figures 1 and 2, the variations in the power supply voltage applied to terminal VEXT would have to be on the order of one Vtp (e.g., around 0.7 V), in order to potentially cause oscillation.

The circuit of Figure 1 also provides such hysteresis in a manner which is not dependent upon relative device sizes, and ratios of device sizes. The amount of hysteresis depends upon the threshold voltage of the number of transistors which feedback transistor 32 shorts out upon VEXT reaching the positive-going trip point level. As is well known in the art, the threshold voltage of a MOS transistor, such as transistors 10, 12, 14 and 16, does not strongly depend upon the transistor channel length (except for very short channel-length transistors, such as below one micron), but instead depends more on the doping level of the wells and upon the dose of a threshold adjust ion implant, both of which are readily controllable in modern technology. Even for relatively long channel length transistors, however, the W/L ratio of the transistor strongly depends upon the patterned and etched dimensions of the gate which often, for modern integrated circuits, correspond to the minimum feature size achievable by the particular manufacturing process.

In this embodiment, the preferred channel length for transistors 10, 12, 14 and 16 is on the order of 2.0 microns. Since the hysteresis is defined by the threshold voltages of transistors 10, 12, 14 and 16, and since the threshold voltage of transistors having such a channel length does not strongly vary with variations in the physical width of the gate electrode, the hysteresis of the circuit of Figure 1 is more controllable relative to conventional circuits in which the hysteresis depends upon device sizes and ratios. Furthermore, it should be noted that the width of the hysteresis in the transfer characteristic can be easily selectable in the design of the circuit of Figure 1, by determining the number of transistors shorted out by the feedback transistor 32.

Although the invention has been described in detail herein with reference to its preferred embodiment, it is to be understood that this description is by way of example only, and is not to be construed in a limiting sense. It is to be further understood that numerous changes in the details of the embodiments of the invention, and additional embodiments of the invention, will be apparent to, and may be made by, persons of ordinary skill in the art having reference to this description. Such changes can include, without limitation thereto, the use of opposite conductivity type transistors from those shown, the use of n-channel or p-channel transistors only rather than CMOS, and the use of an n-channel transistor for feedback transistor 32 (with its gate connected to the next prior or succeeding inverter in the chain). It is contemplated that such changes and additional embodiments are within the true scope of the invention as claimed below.

**Claims**

1. A voltage detection circuit, comprising:

    a plurality of load devices (10, 12, 14, 16) connected in series between a terminal ($V_{EXT}$) and a compare node (18);

    a drive transistor (20) having its gate coupled to a reference voltage ($V_{REF}$) and having its source-to-drain path connected between said compare node (18) and a drive node; and

    a feedback transistor (32) having its gate coupled to said drive node and being conductive when the voltage at the compare node (18) exceeds the reference voltage ($V_{REF}$)-,characterized by
    said feedback transistor (32) having its source-to-drain path connected in parallel to at least one of said load devices (10, 12, 14, 16), so that said at least one load device (10, 12, 14, 16) in parallel with said source-to-drain path of said feedback transistor (32) is shorted out by said feedback transistor (32) when said feedback transistor (32) is conductive.

2. The circuit of claim 1, wherein said load devices (10, 12, 14, 16) comprise diodes.

3. The circuit of claim 1, wherein said load devices (10, 12, 14, 16) each comprise a MOS transistor having its gate coupled to its drain.

4. The circuit of any preceding claim, further comprising:

    a discharge transistor (21), having its source-to-drain path connected between said drive node and a common potential, and having its gate coupled to said reference voltage-($V_{REF}$).

5. The circuit of claim 4, wherein the width-to-length ratio of said discharge transistor (21) is substantially smaller than that of said drive transistor (20).

6. The circuit of any preceding claim, further comprising:

    a buffer (26p, 26n) having its input coupled to said drive node; wherein said gate of said feedback transistor (32) is coupled to said drive node via said buffer (26p, 26n).

7. The circuit of any preceding claim, further comprising:

    an output buffer (28, 30), having its input coupled to said drive node and having an output, said output buffer (28, 30) biased by the voltage at said terminal ($V_{EXT}$).

8. The circuit of any preceding claim, wherein said source-to-drain path of said feedback transistor (32) is connected in parallel to a plurality of said load devices (10, 12, 14, 16).

9. The circuit of any preceding claim, wherein said feedback transistors (32) is conductive responsive to said drive transistor (20) being conductive.

**Patentansprüche**

1. Schaltung zum Feststellen einer Spannung, mit:
    mehreren Lastbauelementen (10, 12, 14, 16), die in Serie zwischen eine Klemme ($V_{EXT}$) und einen Vergleichsschaltungspunkt (18) geschaltet sind;
    einem Ansteuertransistor (20), dessen Gate an eine Referenzspannung ($V_{REF}$) gelegt ist und dessen Source-Drain-Strecke zwischen dem Vergleichsschaltungspunkt (18) und einem Ansteuerschaltungspunkt liegt; und
    einem Rückkopplungstransistor (32), dessen Gate mit dem Ansteuerschaltungspunkt verbunden ist und der leitend ist, wenn die Spannung am Vergleichsschaltungspunkt (18) die Referenzspannung ($V_{REF}$) übersteigt,
    gekennzeichnet durch
    die Parallelschaltung der Source-Drain-Strecke des Rückkopplungstransistors (32) zu wenigstens einem der Lastbauelemente (10, 12, 14, 16), so daß das wenigstens eine Lastbauelement (10, 12, 14, 16) parallel zu der Source-Drain-Strecke des Rückkopplungstransistors (32) von dem Rückkopplungstransistor (32) kurzgeschlossen wird, wenn der Rückkopplungstransistor (32) leitend ist.

2. Schaltung nach Anspruch 1, bei welcher die Lastbauelemente (10, 12, 14, 16) Dioden sind.

3. Schaltung nach Anspruch 1, bei welcher die Lastbauelemente (10, 12, 14, 16) jeweils einen MOS-Transistor umfassen, dessen Gate und Drain verbunden sind.

4. Schaltung nach einem der vorhergehenden Ansprüche, ferner enthaltend einen Entladungstransistor (21), dessen Source-Drain-Strecke zwischen den Ansteuerschaltungspunkt und ein gemeinsames Potential eingefügt ist und dessen Gate an die Referenzspannung ($V_{REF}$) gelegt ist.

5. Schaltung nach Anspruch 4, bei welcher das Verhältnis von Breite zu Länge des Entladungstransistors (21) wesentlich kleiner als das des Ansteuertransistors (20) ist.

6. Schaltung nach einem der vorhergehenden Ansprüche, ferner enthaltend einen Puffer (26p, 26n), dessen Eingang mit dem Ansteuerschaltungspunkt verbunden ist, wobei das Gate des Rückkopplungstransistors (32) über den Puffer (26p, 26n) mit dem Ansteuerschaltungspunkt verbunden ist.

7. Schaltung nach einem der vorhergehenden Ansprüche, ferner enthaltend einen Ausgangspuffer (28, 30), dessen Eingang mit dem Ansteuerschaltungspunkt verbunden ist und der einen Ausgang aufweist, wobei der Ausgangspuffer (28, 30) durch die Spannung an dem Anschluß ($V_{EXT}$) vorgespannt ist.

8. Schaltung nach einem der vorhergehenden Ansprüche, bei welcher die Source-Drain-Strecke des Rückkopplungstransistors (32) parallel zu mehreren der Lastbauelemente (10, 12, 14, 16) geschaltet ist.

9. Schaltung nach einem der vorhergehenden Ansprüche, bei welcher der Rückkopplungstransistor (32) abhängig davon leitend ist, daß der Ansteuertransistor (20) leitet.

## Revendications

1. Circuit de détection de tension, comprenant:
   - une pluralité de dispositifs de charge (10, 12,14,16) connectés en série entre une borne ($V_{ext}$) et un noeud de comparaison (18);
   - un transistor d'attaque (20) ayant sa grille couplée à une tension de référence ($V_{ref}$) et ayant son trajet source-drain connecté entre ledit noeud de comparaison (18) et un noeud d'attaque; et
   - un transistor de réaction (32) ayant sa grille couplée audit noeud d'attaque et étant conducteur lorsque la tension au noeud de comparaison (18) est supérieure à la tension de référence ($V_{ref}$), caractérisé par ledit transistor de réaction (32) ayant son trajet source-drain connecté en parallèle sur au moins l'un desdits dispositifs de charge (10,12,14,16), de manière que ledit au moins un dispositif de charge (10,12,14,16) en parallèle avec ledit trajet source-drain dudit transistor de réaction (32) est court-circuité par ledit transistor de réaction (32) lorsque ledit transistor de réaction (32) est conducteur.

2. Circuit selon la revendication 1, dans lequel lesdits dispositifs de charge (10,12,14,16) comprennent des diodes.

3. Circuit selon la revendication 1, dans lequel lesdits dispositifs de charge (10,12,14,16) comprennent chacun un transistor MOS ayant sa grille couplée à son drain.

4. Circuit selon l'une quelconque des revendications précédentes, comprenant en outre un transistor de décharge (21) ayant son trajet source-drain connecté entre ledit noeud d'attaque et un potentiel commun et ayant sa grille couplée à ladite tension de référence ($V_{ref}$).

5. Circuit selon la revendication 4, dans lequel le rapport largeur/longueur dudit transistor de décharge (21) est substantiellement plus petit que celui dudit transistor d'attaque (20).

6. Circuit selon l'une quelconque des revendications précédentes, comprenant en outre un tampon (26p,26n) ayant son entrée couplée audit noeud d'attaque; dans lequel ladite grille dudit transistor de réaction (32) est couplée audit noeud d'attaque à travers ledit tampon (26p, 26n).

7. Circuit selon l'une quelconque des revendications précédentes, comprenant en outre un tampon de sortie (28,30) ayant son entrée couplée audit noeud d'attaque et ayant une sortie, ledit tampon de sortie (28,30) étant polarisé par la tension à ladite borne ($V_{ext}$).

8. Circuit selon l'une quelconque des revendications précédentes, dans lequel ledit trajet source-drain dudit transistor de réaction (32) est connecté en parallèle sur une pluralité desdits dispositifs de charge (10, 12,14,16).

9. Circuit selon l'une quelconque des revendications précédentes, dans lequel ledit transistor de réaction (32) est conducteur en réponse audit transistor d'attaque (20) lorsqu'il est conducteur.

FIG. 1

FIG. 2